# DEMANDE DE BREVET EUROPEEN

(11) **EP 1 722 422 A2**
(43) Date de publication de la demande: **15.11.2006**
(21) Numéro de dépôt: 06290736.5
(22) Date de dépôt: 09.05.2006
(51) Int. Cl.: H01L 27/146

(54) **Circuit intégré comprenant une photodiode de type à substrat flottant et procédé de fabrication correspondant**

(30) Priorité: 13.05.2005 FR 0504835
(71) Demandeur: STMICROELECTRONICS SA, 92120 Montrouge (FR)
(72) Inventeur: Roy, François, 38130 Seyssins (FR); Tournier, Arnaud, 38000 Grenoble (FR)
(74) Mandataire: Zapalowicz, Francis

(57) **Abrégé**

Circuit intégré comprenant au moins une photodiode (PD) associée à un transistor de lecture (TR), ladite photodiode comportant un empilement de trois couches semi-conductrices comportant une couche enterrée (CE) et une couche supérieure incorporant la zone de drain (D) et/ou de source (S) du transistor. La couche enterrée (CE) est électriquement isolée de la couche supérieure (4) et polarisable indépendamment de la couche supérieure (4).

## Description

L'invention concerne la microélectronique, notamment les circuits intégrés comportant des photodiodes de type à substrat flottant.

Les capteurs d'image à base de composants semi-conducteurs tirent profit du principe de la conversion des photons en paires électrons-trous dans le silicium. Plus précisément, les charges créées dans les zones photosensibles sont stockées dans la photodiode et sont ensuite lues grâce à un système électronique. Ce système électronique, qui commande la photodiode, comporte notamment un transistor de lecture réalisant la conversion des charges stockées dans la photodiode en grandeur électrique.

L'invention s'applique avantageusement mais non limitativement aux capteurs d'image CMOS, et plus particulièrement aux capteurs VMIS (« Vth Modulation Image Sensor », en langue anglaise), qui sont des capteurs d'image s'appuyant sur la modulation de la tension de seuil d'un transistor MOS. On pourra, à ce sujet, se référer à l'article de Takashi MIIDA et al., « A 1.5 Mpixel Imager with Localized Hole Modulation Method », ISSCC Dig. Tech. Pap., pp. 42-43, 7.2002.

Ce type de transistor CMOS est constitué d'une photodiode enterrée et d'un transistor MOS légèrement modifié, du fait que son substrat est un substrat flottant, c'est-à-dire qu'on ne peut accéder à son potentiel, par l'intermédiaire d'une électrode par exemple. Ce substrat flottant joue le rôle d'une zone de stockage de charges lors de l'intégration de celles-ci, c'est-à-dire lorsque la lumière incidente génère des paires électrons-trous dans les zones photosensibles.

Un autre type de transistors auxquels s'applique avantageusement l'invention sont les transistors de type BCMD (« Bulk Charge Modulated Device », en langue anglaise). Ces transistors comprennent, en particulier, une zone .de stockage située sous la grille du transistor de façon à faciliter l'intégration des charges. Ces transistors sont décrits précisément dans l'article de Jaroslav Hyne-cek « BCMD-An Improved Photosite Structure for High Density Image Sensors », IEEE Transactions On Electron Devices, Vol. 3 8, N° 5, Mai 1991.

Classiquement, le fonctionnement d'un circuit intégré comprenant une photodiode associée à un transistor de lecture, fonctionne selon trois phases distinctes : une phase d'intégration, une phase de lecture, et une phase de réinitialisation.

Durant la phase d'intégration, les charges photogénérées dans les zones photosensibles de la photodiode par les photons incidents vont être attirées puis stockées dans le substrat flottant et plus particulièrement au niveau de la zone de stockage située sous la grille du transistor dans le cas des transistors de type BCMD par exemple. Cette accumulation de charges va provoquer une variation de la tension de seuil du transistor MOS, qui va être mesurée lors de la phase de lecture, en connectant le transistor en montage dit « suiveur » (« source follower » en langue anglaise) et en lisant la polarisation de la source.

Durant la phase de réinitialisation, les charges accumulées vont être expulsées hors du substrat flottant vers le support («bulk» en langue anglaise) de la photodiode via une couche enterrée, comprise dans la couche de la photodiode située entre le substrat flottant et le support. Celle-ci constituait une barrière pour les charges photo-générées durant les deux premières phases.

A l'issue de la phase de réinitialisation, le substrat flottant et la couche enterrée se retrouvent alors complètement vidés de ses charges.

De façon à optimiser la phase de réinitialisation, on cherche à obtenir une amplitude en tension maximale entre le support et la couche supérieure de la photodiode. Pour cela, on applique sur la grille et sur le drain des tensions de l'ordre de 6 à 8 volts, c'est-à-dire très supérieures aux polarisations standards généralement utilisées aujourd'hui en technologie CMOS, qui varient entre 0 et 3,3 volts.

En effet, la couche enterrée étant reliée au drain, sa polarisation de la couche enterrée tend à s'aligner sur celle du drain. Aussi, pour diriger les charges vers le support de la photodiode lors de la phase de réinitialisation, il est nécessaire d'utiliser des valeurs de tension relativement élevées et en outre de contrôler très précisément les dopages et l'épaisseur de la couche enterrée au cours de la réalisation, ce qui est très difficilement réalisable.

Par ailleurs, durant la phase d'intégration, la polarisation du substrat flottant doit pouvoir atteindre une valeur minimale de manière que la différence de potentiel entre un substrat flottant vide de charges et plein de charges (« swing » en langue anglaise) soit la plus grande possible.

Par conséquent pour favoriser la phase d'intégration et de lecture et ainsi optimiser les performances électroniques du circuit (par exemple la dynamique de la tension de sortie du circuit), il est préférable que la zone de stockage soit fortement dopée.

Par contre un faible dopage de la zone de stockage favorise la phase de réinitialisation.

L'invention vise à apporter une solution à ces problèmes.

Un but de l'invention est de proposer un circuit intégré comprenant une photodiode, avec une phase de réinitialisation optimale sans entraîner la dégradation de la phase d'intégration et de lecture.

A cet effet, selon un premier aspect de l'invention, il est proposé un circuit intégré comprenant au moins une photodiode associée à un transistor de lecture, ladite photodiode comportant un empilement de trois couches semi-conductrices comportant une couche enterrée et une couche supérieure incorporant la zone de drain et/ou de source du transistor.

Selon une caractéristique générale de ce premier aspect de l'invention, la couche enterrée est électriquement isolée de la couche supérieure et polarisable indépendamment de la couche supérieure.

Ainsi il est possible d'utiliser une zone de stockage fortement dopée (jusqu'à trois fois plus que pour une photodiode standard) de façon à optimiser les performances du circuit durant la phase d'intégration et de lecture, puis de réaliser une réinitialisation efficace malgré le fort dopage de la zone de stockage. En effet, la réinitialisation est réalisée en polarisant la couche enterrée à une valeur minimale grâce à la prise de contact sur celle-ci, tout en appliquant au drain une tension conforme aux polarisations standards généralement utilisées en technologie CMOS, par exemple 3,3 volts.

En d'autres termes, durant la phase de réinitialisation, au lieu d'accroître l'amplitude de la tension entre la couche enterrée et le drain en augmentant la valeur de la tension de polarisation du drain, on diminue puis on fixe à une valeur minimale celle de la couche enterrée

En effet, selon ce premier aspect de l'invention, il est possible de polariser, durant la phase de réinitialisation, la couche enterrée de la photodiode autour de 0 volt. Le potentiel de la couche enterrée étant fixé et faible, en polarisant le drain à 3,3 volts, l'amplitude en tension entre la couche enterrée et la couche supérieure durant la phase de réinitialisation est suffisamment importante pour que celle-ci soit optimale.

En outre, en polarisant la couche enterrée indépendamment de la couche supérieure, on diminue les effets néfastes dus au manque de contrôle sur la polarisation de la couche enterrée entre la phase de réinitialisation et la phase d'intégration.

Selon un mode de réalisation de ce premier aspect, le circuit intégré comprend une zone de contact semi-conductrice du même type de conductivité que la couche enterrée et électriquement isolée de la couche supérieure formée entre la surface externe du circuit intégré et la couche enterrée, de façon à pouvoir polariser ladite couche enterrée.

Cette zone de contact permet, à l'aide d'une électrode, de polariser directement la couche enterrée, notamment pour la phase de réinitialisation.

La zone de contact peut, par exemple, être électriquement isolée de la couche supérieure par une jonction PN formée entre la zone de contact et la couche médiane de l'empilement, ladite couche supérieure étant située au-dessus d'une partie de la couche médiane.

En variante, la zone de contact peut être isolée de la couche supérieure par une tranchée d'isolation s'étendant depuis la surface supérieure de la couche supérieure et au-delà de la couche médiane de l'empilement.

Cette couche d'isolant a pour avantage d'être particulièrement fine, ce qui permet de réduire fortement la surface du circuit intégré.

De préférence, la zone de contact comprend une zone supérieure, une zone intermédiaire moins fortement dopée que la zone supérieure, et une zone inférieure moins fortement dopée que la zone intermédiaire.

La variation du dopage de la zone de contact a pour avantage de faciliter la polarisation de la couche enterrée à une tension minimale.

La zone inférieure peut, par exemple, être dopée avec une concentration de dopants de l'ordre de 10¹⁷ at/cm³.

La zone intermédiaire peut, par exemple, être dopée avec une concentration de dopants de l'ordre de 1018 at/cm³.

La zone supérieure peut être par exemple dopée avec une concentration de dopants de l'ordre de 10¹⁹ à 10²⁰ at/cm³.

Selon un autre aspect de l'invention, il est proposé un capteur d'image comprenant au moins un pixel associé à un circuit intégré, tel que défini ci-avant.

Selon un autre aspect de l'invention, il est proposé un procédé de fabrication d'un circuit intégré comprenant la réalisation d'une photodiode et d'un transistor de lecture, la réalisation de ladite photodiode comportant la formation d'un empilement de trois couches semi-conductrices, ladite formation de l'empilement comprenant la réalisation d'une couche enterrée, et la formation d'une couche supérieure sur laquelle on réalise la zone de source et/ou de drain.

Selon une caractéristique générale de cet autre aspect de l'invention, on isole électriquement la couche enterrée de la couche supérieure, de façon que ladite couche enterrée soit polarisable indépendamment de la couche supérieure.

De préférence, préalablement à la réalisation de la zone de drain ou de source du transistor, on réalise, entre la surface externe du circuit intégré et la couche enterrée, une zone de contact semi-conductrice du même type de conductivité que la couche enterrée et électriquement isolée de la couche supérieure, de façon à pouvoir polariser ladite couche enterrée.

De préférence, la couche supérieure est réalisée sur une partie de la couche médiane de l'empilement, et on isole électriquement la zone de contact de la couche supérieure par une jonction PN formée entre la zone de contact et la couche médiane de l'empilement.

En variante, on isole la zone de contact de la couche supérieure par une tranchée d'isolation s'étendant depuis la surface supérieure de la couche supérieure et au-delà de la couche médiane de l'empilement..

De préférence, on réalise la zone de contact par trois implantations successives, de façon à créer une zone inférieure, une zone intermédiaire, puis une zone supérieure, simultanément à la réalisation des zones de source et de drain du transistor, de façon que ladite zone supérieure soit plus fortement dopée que la zone intermédiaire qui est elle-même plus fortement dopée que la zone inférieure.

Par exemple, la zone inférieure peut être dopée de préférence en utilisant des doses de l'ordre de 6.10¹² at/cm².

La zone intermédiaire peut être de préférence dopée en utilisant des doses de l'ordre de 10¹³ at/cm².

La zone supérieure peut être, quant à elle, dopée de préférence en utilisant des doses de l'ordre de 10¹⁵ at/cm².

D'autres avantages et caractéristiques de l'invention apparaîtront à l'examen de la description détaillée de plusieurs modes de réalisation et d'un mode de mise en oeuvre, nullement limitatifs, et des dessins annexés, sur lesquels :
- la figure 1 illustre de façon schématique un capteur d'image selon l'invention formé de plusieurs cellules, équipées de photodiodes, selon l'invention ;
- la figure 2 représente un mode de réalisation d'un circuit intégré selon l'invention ;
- la figure 3 représente les phases de fonctionnement d'un circuit intégré selon l'invention ;
- les figures 4 à 10 illustrent schématiquement les principales étapes d'un mode de mise en oeuvre du procédé de fabrication d'un circuit intégré selon l'invention ;
- la figure 11 représente un autre mode de réalisation d'un circuit intégré selon l'invention ;
- les figures 12 à 14 représentent différents exemples de réalisation sur silicium, d'un circuit intégré selon l'invention.

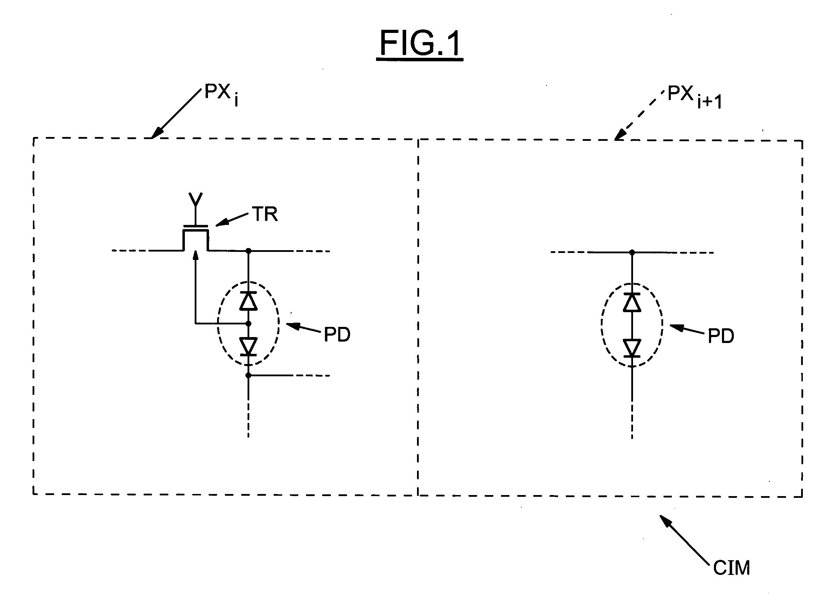

Sur la figure 1, la référence CIM désigne d'une façon générale un capteur d'image formé d'une matrice de cellules (ou pixel) PXi, comportant chacune une photodiode PD ainsi qu'un transistor de lecture TR connecté à la photodiode PD. Chaque cellule PXi peut comprendre des moyens de commande supplémentaires connectés au transistor de lecture TR, par exemple un transistor de remise à zéro, un transistor de sélection et un transistor suiveur.

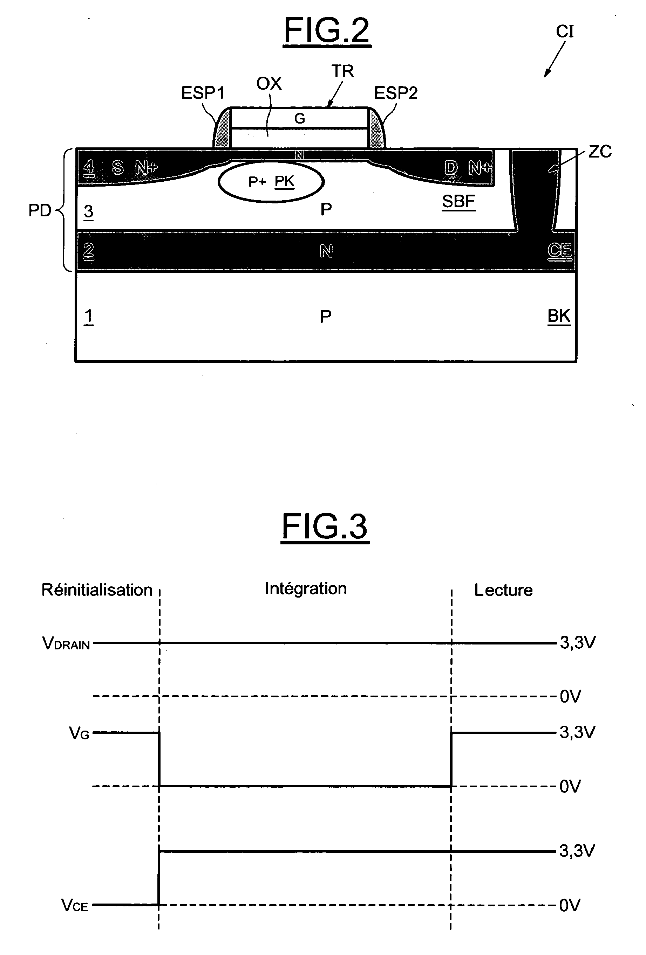

La figure 2 illustre plus en détail la structure semi-conductrice de la photodiode PD d'une cellule PXi.

La référence CI désigne un circuit intégré selon un premier mode de réalisation de l'invention, comprenant la photodiode PD formée sur une couche 1 de substrat BK (« Bulk » en langue anglaise), ici dopée P et constituant le support du circuit intégré.

Le circuit intégré CI comprend également le transistor de lecture TR d'une cellule PXi.

La photodiode PD comprend un empilement 2, 3 et 4 de couches semi-conductrices situées au-dessus de la couche 1 de support.

Cet empilement comprend une couche semi-conductrice 2, ici dopée N, au-dessus du support BK.

La couche 2 forme une couche enterrée CE, c'est-à-dire une barrière pour les charges photogénérées dans la zone photosensible de la photodiode PD.

La couche enterrée CE est surmontée d'une couche médiane 3, qui comprend une zone dite de substrat flottant SBF, c'est-à-dire une zone fermée dont on ne peut modifier ou accéder au potentiel à l'aide par exemple d'une électrode.

La zone de substrat flottant SBF comprend, dans cet exemple, une zone de stockage (« pocket » en langue anglaise) PK surdopée P+. En effet, au lieu de stocker les charges photogénérées dans l'ensemble du substrat flottant SBF, celles-ci sont stockées dans la zone de stockage PK localisée sous la grille G du transistor de lecture TR. Cependant, ce mode de réalisation peut également s'appliquer à des photodiodes comprenant un substrat flottant sans zone de stockage.

Le circuit intégré CI comprend une dernière couche 4, ici dopée N, de façon à réaliser la photodiode PD.

Cette dernière couche 4, dopée N, comprend la source S et le drain D du transistor de lecture TR, les deux zones étant dopées N+. Dans le cas d'un capteur d'image CMOS, un transistor de lecture est associé à chaque pixel.

Au-dessus de l'empilement de couches semi-conductrices, se trouve la grille G du transistor de lecture TR qui est isolée de l'empilement des couches semi-conductrices par une couche d'oxyde OX.

En outre, le transistor de lecture TR comprend dans cet exemple deux espaceurs ESP1 et ESP2 de chaque côté de la grille G.

La photodiode PD est donc ici formée de trois couches définissant deux jonctions PN (diodes), à savoir une jonction supérieure formée par la couche 4 dopée N et la couche médiane 3 dopée P, servant à réaliser la zone de substrat flottant SBF, et une jonction inférieure formée de la couche 3 et de la couche 2 de la couche enterrée CE. La dernière couche 1 formant le substrat BK sert de support et a une polarité fixée et constante.

Par ailleurs, de façon à pouvoir ajuster le potentiel de la couche enterrée CE, la photodiode PD comprend, au sein de la zone de substrat flottant SBF, une zone de contact ZC semi-conductrice, du même type de polarité que la couche enterrée, c'est-à-dire N dans cet exemple.

La zone de contact ZC et la couche enterrée CE sont isolées de la couche supérieure comprenant la zone de drain et de source, par une jonction PN formée entre le substrat flottant SBF dopé P et la zone de contact ZC dopée N.

Le chronogramme de la figure 3 illustre en fonction des différentes phases de fonctionnement de la photodiode la variation des tensions appliquées au drain, à la grille et à la couche enterrée.

Durant tout le fonctionnement de la photodiode, la polarisation du drain est maintenue constante à une faible polarisation, ici 3,3 volts.

La tension de la grille, quant à elle, varie entre la tension maximale, ici 3,3 volts, durant les phases de réinitialisation et de lecture, et minimale, ici 0 volt, pendant la phase d'intégration.

En ce qui concerne la polarisation de la couche enterrée, celle-ci varie entre la tension minimale, ici autour de 0 volt, pendant la phase de réinitialisation et la tension maximale, ici 3,3 volts, pendant les phases d'intégration et de lecture.

En pouvant ajuster le potentiel de la couche enterrée, il est alors possible de le diminuer au minimum, tout en s'assurant que la diode créée entre le support BK et la couche enterrée CE ne passe pas en polarisation directe. On réalise alors, pendant la phase de réinitialisation, ce qui est couramment appelé par l'homme du métier « une pente de potentiel » entre la zone de drain à 3,3 volts et la couche enterrée à 0 volts. Cette « pente de potentiel » ainsi créée permet d'optimiser la déplétion de la couche enterrée CE tout en utilisant des polarisations standards.

Par conséquent, le circuit intégré CI selon l'invention permet de procéder aux différentes phases de réinitialisation d'intégration et de lecture à l'aide de tensions dont l'amplitude varie entre 0 et 3,3 volts, comme illustré sur la figure 3.

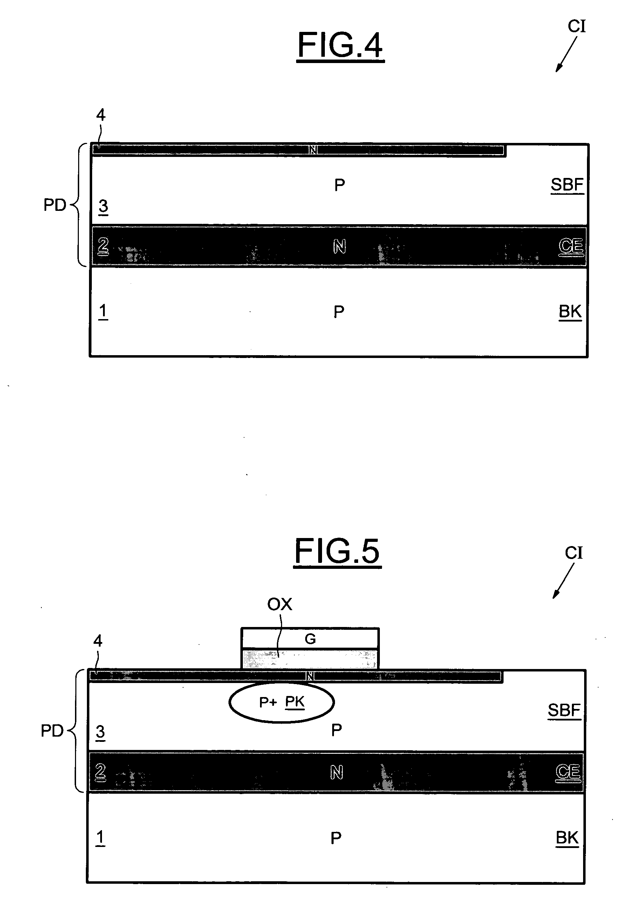

On se réfère à présent plus particulièrement aux figures 4 à 10, qui décrivent les principales étapes d'un mode de mise en oeuvre du procédé de réalisation du circuit intégré représenté sur la figure 2, selon l'invention.

On réalise tout d'abord (figure 4) sur la couche 1 servant de support BK, ici dopée P, l'empilement de couches semi-conductrices 2, 3 et 4, formant la photodiode PD.

La couche 2 de la photodiode, ici dopée N, définit la couche enterrée CE. La couche médiane 3 ici dopée P, est la couche de l'empilement servant à la réalisation de la zone de substrat flottant SBF de la photodiode PD. La couche 4 semi-conductrice dopée N, est réalisée quant à elle sur une partie de la couche médiane 3.

Après avoir réalisé l'empilement de couches semi-conductrices 1 à 4 de façon classique, on réalise de façon classique (figure 5) la zone de stockage par implantation, puis la grille G du transistor de lecture TR reposant sur la couche semi-conductrice 4, dopée N, au-dessus de la zone de stockage. La grille G est séparée de la couche supérieure 4 de la photodiode par une couche d'oxyde OX. Il est possible de ne pas réaliser la zone de stockage, les charges étant alors stockées dans le substrat flottant SBF.

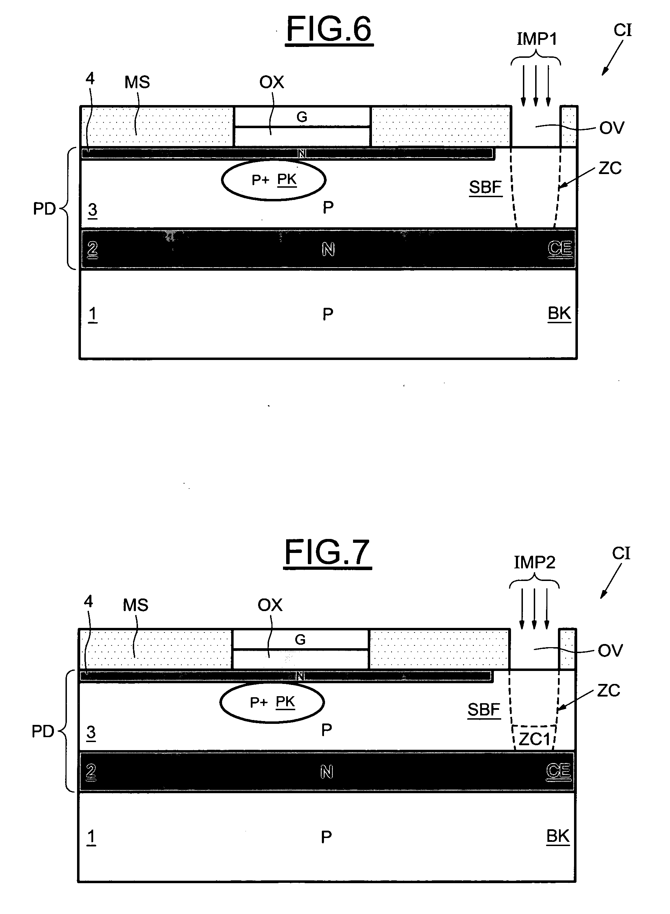

Puis, on dépose (figure 6) une couche de résine sur la couche supérieure 4 et sur la partie de la couche médiane 3 non recouverte par la couche 4. On définit ensuite par gravure de la résine une ouverture OV localisée sur la couche médiane 3 non recouverte par la couche 4. On a par conséquent réalisé un masque de résine MS sur la couche 4 et une partie de la couche 3. Seule l'ouverture OV, issue de la gravure de la résine, subsiste sur la partie découverte de la couche 3, tel que représenté sur la figure 6.

Une fois le masque MS réalisé, on procède à une première implantation IMP1, de façon à créer la zone de contact ZC permettant une reprise de contact sur la couche enterrée CE. Cette première implantation doit être réalisée à une profondeur relativement importante, de façon que la zone de contact traverse la couche 3 jusqu'à la couche enterrée CE. Par exemple, pour une technologie 0,13 µm, elle peut être réalisée à une profondeur de 0,6 ym avec des doses de l'ordre de 6.10¹² at/cm² et une énergie de 800 Kev. Les dopants utilisés peuvent être par exemple du phosphore. Plus généralement, le procédé de dopage peut utiliser tout gaz dopant électriquement actif, de type N dans ce cas ou de type P dans le cas d'un transistor à canal P (ou PMOS).

Comme on peut le voir sur la figure 7, à l'issue de la première implantation IMP1, on procède toujours avec le même masque MS à une deuxième implantation IMP2 au niveau de l'ouverture OV.

La profondeur de l'implantation IMP2 est inférieure à celle de l'implantation IMP1. Elle est de préférence de l'ordre de 0,4 nm à l'aide de doses ayant une concentration de l'ordre de 10¹³ at/cm² avec une énergie de 400 Kev.

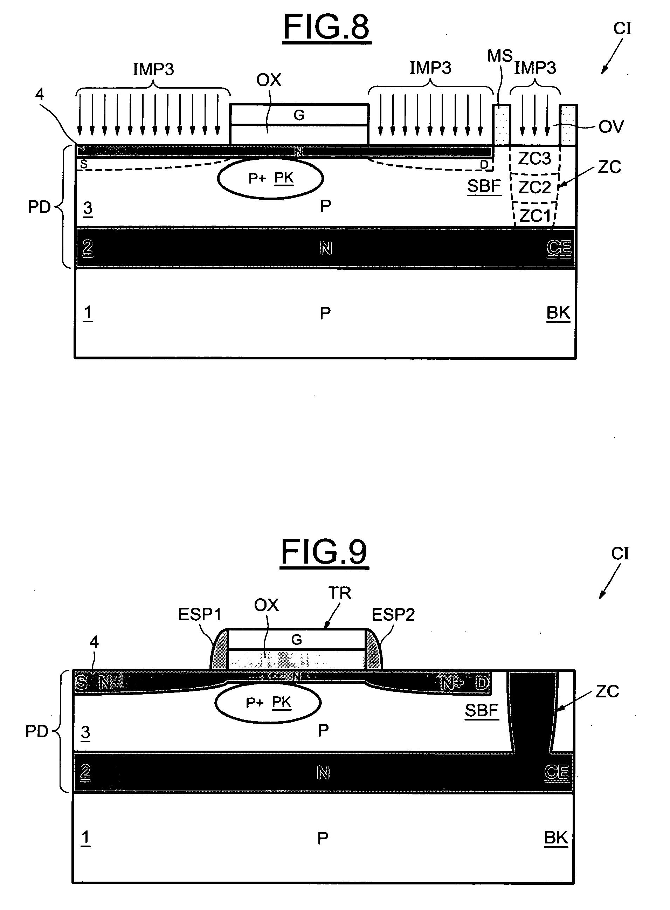

A l'issue de la deuxième implantation IMP2, on retire le masque de résine, puis on réalise un autre masque MS en procédant comme décrit ci-dessus, sur la partie de la couche 3 non recouverte par la couche supérieure 4 et de façon à conserver l'ouverture OV (figure 8). La couche supérieure 4 est entièrement découverte, à l'exception de la partie recouverte par la grille G du transistor TR. On procède alors à une troisième implantation IMP3, de façon à obtenir les zones de source S et de drain D dopées N+. La troisième implantation IMP3 est également réalisée à travers l'ouverture OV, de façon à implanter au niveau de la zone de contact ZC des doses de dopants ayant une concentration de l'ordre de 10¹⁵ at/cm² et à une profondeur de 0,1 µm, de préférence, avec une énergie de quelques Kev.

On obtient ainsi, à l'issue des trois implantations IMP1, IMP2 et IMP3, trois zones distinctes au niveau de la zone de contact ZC, que sont ZC1, ZC2 et ZC3.

La concentration des différentes zones ZC1 à ZC3 va de la plus faible à la plus importante, de façon à favoriser au moment de la phase de réinitialisation la polarisation à une faible tension, de la couche enterrée CE.

Puis, on réalise de façon classique et connue en soi (figure 9) les espaceurs ESP1 et ESP2 du transistor TR au-dessus de la couche 4 sur les flancs de la grille G.

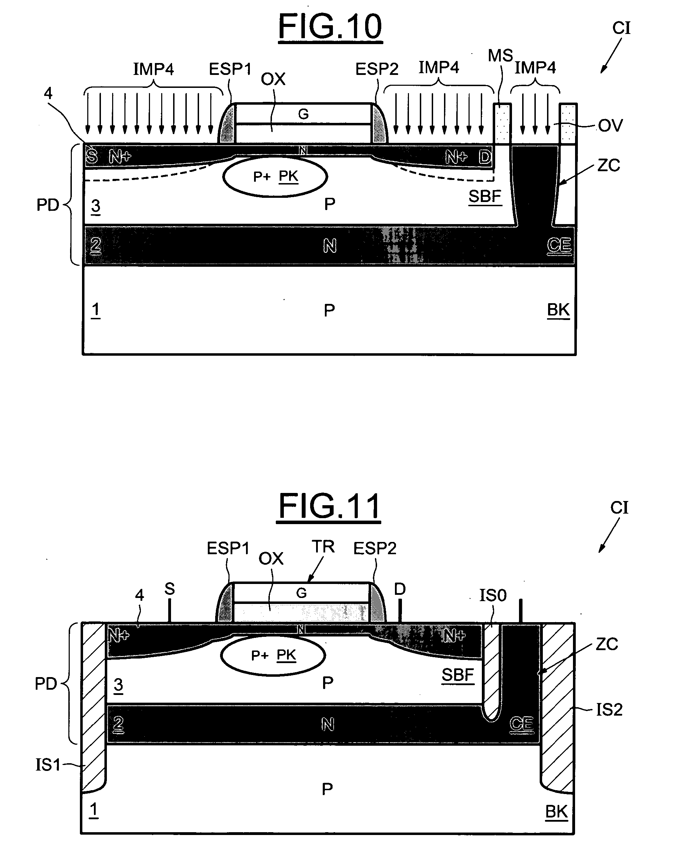

Il est alors possible (figure 10) de procéder à une quatrième implantation IMP4 après avoir réalisé un masque MS au-dessus de la partie découverte de la couche 3, de façon à doper plus profondément les zones de source et de drain S et D.

Le masque MS peut comprendre à nouveau une ouverture OV de façon que la zone de contact ZC bénéficie de la dernière implantation IMP4.

On a représenté sur la figure 11, un autre mode de réalisation du circuit intégré selon l'invention.

Le circuit intégré CI selon cet autre mode de réalisation comprend entre la couche supérieure 4 et la couche médiane 3, d'une part, et la zone de contact ZC, d'autre part, une tranchée d'isolation ISO qui s'étend depuis la surface supérieure de la couche supérieure 4 et au-delà de la couche médiane de l'empilement.

La tranchée d'isolation ISO peut être par exemple du type à tranchées moyennement profondes (MTI : « Medium Trench Isolation » en langue anglaise). Dans ce cas, le matériau isolant utilisé peut être par exemple du dioxyde de silicium.

Ce type d'isolation a pour avantage de permettre la réalisation de circuits intégrés particulièrement compacts puisque la largeur de la tranchée d'isolation est comprise entre 0,2 et 0,3 µm, alors que la largeur à la surface du circuit intégré de l'isolation réalisée par la jonction PN varie entre 0,6 et 0,7 µm.

Bien entendu, il serait possible de réaliser une tranchée d'isolation du type STI (« Shallow Trench Isolation » en langue anglaise) entre la couche supérieure et la zone de contact, mais en formant une tranchée d'isolation qui s'étend jusqu'à la couche enterrée et non pas uniquement au-delà de la couche supérieure, on évite la diffusion des dopants des implantations servant à réaliser la zone de reprise de contact ZC, et donc de provoquer un court-circuit entre la couche enterrée CE et la couche supérieure 4.

En effet, si la tranchée d'isolation était plus courte, il existerait alors un risque élevé d'avoir un court-circuit entre la zone de reprise de contact et donc la couche enterrée CE et la couche supérieure 1 comprenant la source S, le drain D et la zone photosensible de la photodiode PD.

Des zones d'isolation IS1 et IS2, par exemple des isolations du type « oxydation localisée » (LOCOS, selon une dénomination bien connue de l'homme du métier) ont été ajoutées pour isoler électriquement le circuit intégré CI de circuits adjacents réalisés sur un même support.

Il est possible de réaliser sur silicium le circuit intégré selon l'invention, selon différentes topologies. Deux configurations sont présentées ci-dessous à titres d'exemples, celles-ci n'étant en aucun cas limitatives.

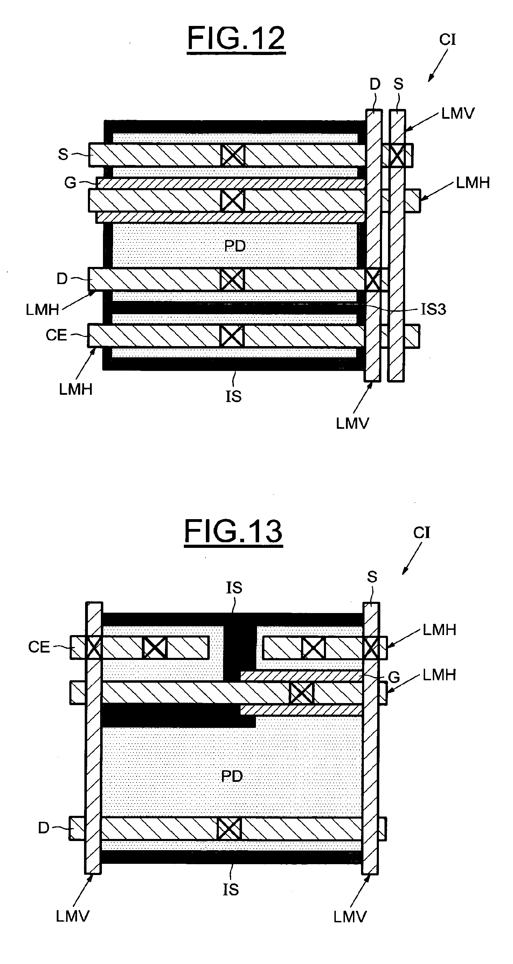

Par exemple, la figure 12 représente la photodiode PD entourée d'un isolant IS. Cet isolant peut être réalisé par une jonction PN, associée à une isolation du type « oxydation localisée» (LOCOS).

La photodiode PD comprend trois lignes de métallisation horizontales LMH pour la prise de contact sur les zones de source S, de grille G et de drain D.

En outre, de façon à permettre une deuxième prise de contact sur les zones de source S et de drain D, le circuit comprend deux lignes de métallisation supplémentaires verticales LMV.

Le circuit intégré CI comporte par ailleurs une isolation IS3 entre la photodiode et une quatrième ligne de métallisation horizontale LMH permettant la reprise de contact sur la couche enterrée CE. Cette isolation IS3 peut être réalisée par exemple par une jonction PN ou une isolation de type MTI tel que décrit ci-dessus.

Sur la figure 13, on a représenté une autre topologie possible pour la réalisation du circuit intégré CI selon l'invention. Dans ce cas, outre le fait d'entourer la photodiode PD, l'isolant IS sépare et isole la couche enterrée CE de la zone de source S, de façon à pouvoir réaliser deux zones de reprise de contact sur une même largeur du circuit intégré. Cette topologie permet de réaliser un circuit intégré particulièrement compact.

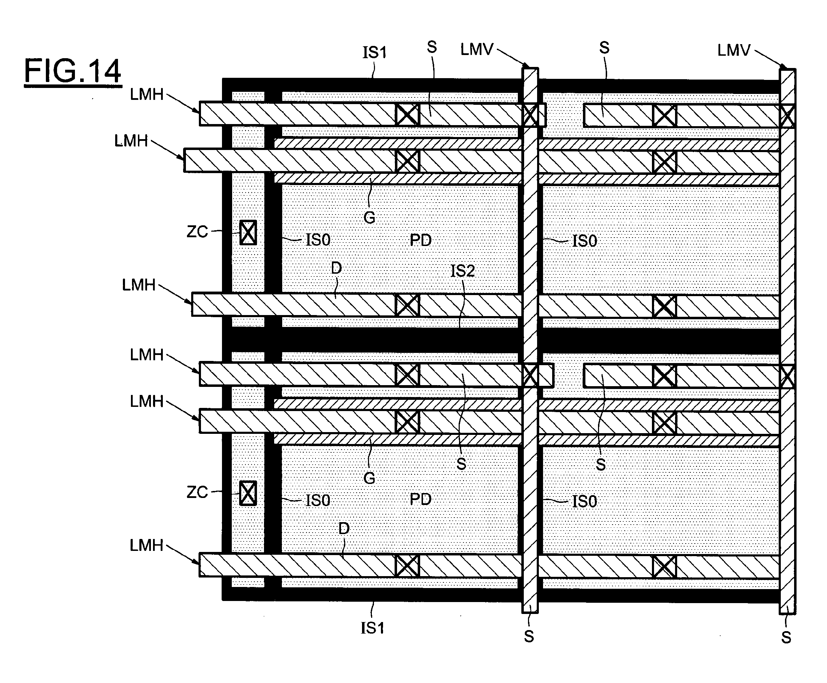

La figure 14 illustre un exemple de topologie pour un circuit intégré selon l'invention, dans le cas où chaque transistor de lecture est associé à un pixel appartenant à une matrice de pixels commandée par ligne.

Sur cette figure, chaque ligne de la matrice comprend deux pixels réalisés sur le même empilement de couches semi-conductrices. Les zones intermédiaires de chaque pixel d'une ligne de la matrice sont isolées par une tranchée d'isolation ISO. Par contre, la couche enterrée de ces pixels est commune à chacun d'entre eux.

Par conséquent, il est possible de polariser la couche enterrée de l'ensemble des pixels d'une même ligne en réalisant une zone de contact unique, par exemple à l'une des extrémités de la ligne de pixels telle que représentée sur la figure 14.

## Revendications

1. Circuit intégré comprenant au moins une photodiode (PD) associée à un transistor de lecture (TR), ladite photodiode comportant un empilement de trois couches semi-conductrices comportant une couche enterrée (CE) et une couche supérieure incorporant la zone de drain (D) et/ou de source (S) du transistor, **caractérisé par le fait que** la couche enterrée (CE) est électriquement isolée de la couche supérieure (4) et polarisable indépendamment de la couche supérieure (4).

2. Circuit intégré selon la revendication 1, comprenant une zone de contact (ZC) semi-conductrice du même type de conductivité que la couche enterrée (CE) et électriquement isolée de la couche supérieure (4), formée entre la surface externe du circuit intégré et la couche enterrée (CE), de façon à pouvoir polariser ladite couche enterrée (CE).

3. Circuit intégré selon la revendication 2, dans lequel la zone de contact (ZC) est électriquement isolée de la couche supérieure (4) par une jonction PN formée entre la zone de contact (ZC) et la couche médiane de l'empilement, ladite couche supérieure (4) étant située au-dessus d'une partie de ladite couche médiane.

4. Circuit intégré selon la revendication 2, dans lequel la zone de contact (ZC) est isolée de la couche supérieure (4) par une tranchée d'isolation (ISO) s'étendant depuis la surface supérieure de la couche supérieure (4) et au-delà de la couche médiane de l'empilement.

5. Circuit intégré selon l'une quelconque des revendications 2 à 4, dans lequel la zone de contact (ZC) comprend une zone supérieure (ZC3), une zone intermédiaire (ZC2) moins fortement dopée que la zone supérieure, et une zone inférieure (ZC1) moins fortement dopée que la zone intermédiaire.

6. Circuit intégré selon la revendication 5, dans lequel la zone inférieure est dopée avec une concentration de dopants de l'ordre de 10¹⁷ at/cm³.

7. Circuit intégré selon la revendication 5 ou 6, dans lequel la zone intermédiaire est dopée est dopée avec une concentration de dopants de l'ordre de 10¹⁸ at/cm³.

8. Circuit intégré selon la revendication 5 à 7, dans lequel la zone supérieure est dopée est dopée avec une concentration de dopants de l'ordre de 10¹⁹ à 10²⁰ at/cm³.

9. Capteur d'image **caractérisé par le fait qu'**il comprend au moins un pixel associé à un circuit intégré selon l'une quelconque des revendications 1 à 8.

10. Procédé de fabrication d'un circuit intégré comprenant la réalisation d'une photodiode (PD) et d'un transistor de lecture (TR), la réalisation de ladite photodiode (PD) comportant la formation d'un empilement de trois couches semi-conductrices, ladite formation de l'empilement comprenant la réalisation d'une couche enterrée (CE), et la formation d'une couche supérieure (4) sur laquelle on réalise la zone de source (S) et/ou de drain (D), **caractérisé par le fait qu'**on isole électriquement la couche enterrée (CE) de la couche supérieure de façon que ladite couche enterrée soit polarisable indépendamment de la couche supérieure (4).

11. Procédé selon la revendication précédente, dans lequel, préalablement à la réalisation de la zone de drain (D) ou de source (S) du transistor (TR), on réalise entre la surface externe du circuit intégré et la couche enterrée, une zone de contact (ZC) semi-conductrice du même type de conductivité que la couche enterrée et électriquement isolée de la couche supérieure, de façon à pouvoir polariser ladite couche enterrée (CE).

12. Procédé selon la revendication 11, dans lequel la couche supérieure (4) est réalisée sur une partie de la couche médiane de l'empilement, et dans lequel on isole électriquement la zone de contact (ZC) de la couche supérieure (4) par une jonction PN formée entre la zone de contact (ZC) et la couche médiane de l'empilement.

13. Procédé selon la revendication 11, dans lequel on isole la zone de contact (ZC) de la couche supérieure par une tranchée d'isolation (ISO) s'étendant depuis la surface supérieure de la couche supérieure (4) et au-delà de la couche médiane de l'empilement.

14. Procédé selon l'une quelconque des revendications 11 à 13, dans lequel on réalise la zone de contact (ZC) par trois implantations successives deux façon à créer une zone inférieure (ZC1), une zone intermédiaire (ZC2) puis une zone supérieure (ZC3) simultanément à la réalisation des zones de source et de drain du transistor, de façon que ladite zone supérieure soit plus fortement dopée que la zone intermédiaire qui est elle-même plus fortement dopée que la zone inférieure.

15. Procédé selon la revendication 14, dans lequel la zone inférieure est dopée en utilisant des doses de l'ordre de 6.10¹² at/cm².

16. Procédé selon la revendication 14 ou 15, dans lequel la zone intermédiaire est dopée en utilisant des doses de l'ordre de 10¹³at/cm².

17. Procédé selon l'une quelconque des revendications 14 à 16, dans lequel la zone supérieure est dopée en utilisant des doses de l'ordre de 10¹⁵ at/cm².
